(19) Europäisches Patentamt
European Patent Office
Office européen des brevets

(11) EP 2 264 113 A2

# (12) EUROPEAN PATENT APPLICATION

(43) Date of publication:
**22.12.2010 Bulletin 2010/51**

(51) Int Cl.:
***C09J 169/00*** *(2006.01)* ***C09J 123/24*** *(2006.01)*
***H01L 21/68*** *(2006.01)*

(21) Application number: **09175317.8**

(22) Date of filing: **06.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **15.06.2009 JP 2009142705**

(71) Applicant: **Sumitomo Bakelite Co., Ltd.**
**Shinagawa-ku**
**Tokyo 140-0002 (JP)**

(72) Inventors:
- **Takeuchi, Etsu**
  **Tokyo 1400002 (JP)**
- **Kusunoki, Junya**
  **Tokyo 1400002 (JP)**
- **Sugiyama, Hiromichi**
  **Tokyo 1400002 (JP)**
- **Kuboyama, Toshiharu**
  **Tokyo 1400002 (JP)**
- **Kawata, Masakazu**
  **Tokyo 1400002 (JP)**

(74) Representative: **Ilgart, Jean-Christophe et al**
**BREVALEX**
**3, rue du Docteur Lancereaux**
**75008 Paris (FR)**

## (54) Temporary bonding adhesive for a semiconductor wafer and method for manufacturing a semiconductor device using the same, and use of a resin composition as a temporary bonding adhesive

(57) To provide a temporary bonding adhesive for a semiconductor wafer that can reduce damage to the semiconductor wafer, is easily detachable, and can shorten the time required for thermal decomposition, and a manufacturing method for a semiconductor device using the same.

A temporary bonding adhesive for a semiconductor device is provided, being a temporary bonding adhesive used for temporarily bonding a semiconductor wafer onto a supporting substrate in order to process a semiconductor wafer, and for detaching a semiconductor wafer from a supporting substrate by heating after processing, containing a resin composition such that the difference between the 95% weight loss temperature and the 5% weight loss temperature is

1 degree Celsius ≤ (95% weight loss temperature) – (5% weight loss temperature) ≤ 300 degrees Celsius.

EP 2 264 113 A2

## Description

### FIELD OF THE INVENTION

The present invention concerns a temporary bonding adhesive for temporarily bonding a semiconductor wafer during processing, and a method for manufacturing a semiconductor device using the same, and use of a resin composition as a temporary bonding adhesive.

### BACKGROUND OF THE INVENTION

In order to carry out processing such as grinding and etching on semiconductor wafers, it is necessary to temporarily bond semiconductor wafers, and various methods for doing so have been proposed. For example, at present, a method wherein a semiconductor wafer is bonded on top of a film for bonding that is a PET film whereon an adhesive layer has been provided is often used.
With this method, if the grinding precision (approximately 1 μm) of a back grinding machine generally used for grinding, and the thickness precision (approximately 5 μm) of a BG (back grind) tape generally used to fix a wafer are put together, the required thickness precision is exceeded, and there is the danger that variability in the thicknesses of the ground wafers may arise.
Additionally, when processing wafers used for through-silicon vias (TSVs), the formation of via holes and films is carried out with a BG tape attached, but at that time the temperature reaches approximately 150 degrees Celsius, and this unfortunately raises the adhesion of the BG tape. Additionally the adhesive layer of the BG tape can be eroded by plating chemicals for film formation, and peeling can thereby occur.
Additionally fragile wafers such as those in compound semiconductors may in some cases, be damaged by mechanical grinding, so they are made thinner by etching. During this etching, there are typically no problems if the amount of etching is such that the aim is merely stress removal, but in cases where several microns worth of ething is done, the BG tape may be deteriorated by the etching chemicals.
On the other hand, a method has come to be utilized where bonding to a supporting substrate having a smooth surface is done, via a bonding material. For example, when etching with the aim of stress removal, heating to a high temperature is necessary, but a PET film cannot withstand such a high temperature, so in such cases, a method using a supporting substrate is preferably utilized.
As the material for bonding to the supporting substrate, bonding materials that soften under high temperatures and thereby make the detachment of the wafer easy, and bonding materials that are dissolved by specific chemicals have been proposed.
However, the handling of such materials is poor, and after detachment, it is necessary to wash residual bonding material that has remained in the interior portions of the semiconductor wafer or device using chemicals or the like.
Additionally, when detaching the semiconductor wafer from the supporting substrate, there is the danger that the thinned wafer cannot withstand this and it breaks. As semiconductor wafers grow ever thinner, this probability can be expected to increase.
For example, Patent Documents 1 and 2 disclose polymers concerning the manufacture of a semiconductor device, although their aims differ from that of the present invention.
As described above, with regard to bonding in order to process a semiconductor wafer, a temporary bonding material was desired for which high precision processing is possible, it is easily detachable, and it does not readily remain on a semiconductor wafer.
Additionally, a manufacturing method for a semiconductor device that decreases the damage to semiconductor wafers, makes high precision processing possible, and can shorten the time needed for thermal decomposition was desired.

### PRIOR ART DOCUMENTS

Patent Documents

Patent Document 1 JP-T 2006-504853
Patent Document 2 JP-T 2006-503335

### SUMMARY OF THE INVENTION

The aim of the present invention is to provide a temporary bonding adhesive for a semiconductor wafer that

reduces damage to the semiconductor wafer, allows for high precision processing, and makes the detachment of the semiconductor wafer after treatment easy, and a method for manufacturing a semiconductor device that reduces damage to the semiconductor wafer, allows for high precision processing, and can shorten the time needed for thermal decomposition.

According to the present invention, a temporary bonding adhesive for a semiconductor wafer is provided that temporarily fixes bonds a semiconductor wafer to a supporting substrate for processing the semiconductor wafer, and that is used after treatment for detaching the semiconductor wafer from the supporting substrate by heating. Said temporary bonding adhesive for a semiconductor wafer contains a resin composition such that the difference between the 95% weight loss temperature and the 5% weight loss temperature is

$$1 \text{ degree Celsius} \leq (95\% \text{ weight loss temperature}) - (5\% \text{ weight loss temperature}) \leq 300 \text{ degrees Celsius.}$$

Additionally according to one mode of the present invention, a temporary bonding adhesive for a semiconductor wafer is provided that temporarily bonds a semiconductor wafer to a supporting substrate for processing the semiconductor wafer, and that is used after treatment for detaching the semiconductor wafer from the supporting substrate by heating, said temporary bonding adhesive for a semiconductor wafer containing a resin composition such that the difference between the 95% weight loss temperature and the 5% weight loss temperature is the following:

$$5 \text{ degree Celsius} \leq (95\% \text{ weight loss temperature}) - (5\% \text{ weight loss temperature}) \leq 80 \text{ degrees Celsius.}$$

Additionally according to the present invention, a method for manufacturing a semiconductor device is provided, comprising a step wherein a temporary bonding adhesive for a semiconductor containing a resin such that the difference between the 95% weight loss temperature and the 5% weight loss temperature is

$$5 \text{ degree Celsius} \leq (95\% \text{ weight loss temperature}) - (5\% \text{ weight loss temperature}) \leq 80 \text{ degrees Celsius}$$

is provided on top of a supporting substrate in the form of a thin layer; a step wherein a semiconductor wafer is placed onto the surface of said supporting substrate provided with a layer, and the semiconductor wafer is stuck to said layer; a step wherein a semiconductor wafer is processed; and a step wherein said semiconductor wafer is removed from said supporting substrate by heating said layer.

The temporary bonding adhesive for a semiconductor wafer of the present invention has the effects of reducing damage to the semiconductor wafer, making high precision processing possible, and making the detachment of the semiconductor wafer after treatment easy. Additionally the method for manufacturing a semiconductor device using said temporary bonding adhesive for a semiconductor wafer has the effects of reducing damage to the semiconductor wafer, making high precision processing possible, and reducing the time needed for thermal decomposition.

## EMBODIMENTS OF THE INVENTION

[Defining Terms]

In the present invention, "5% weight loss temperature" and "95% weight loss temperature" respectively refer to the temperature at which 5% and 95% of the weight is lost when measured by TG/DTA (thermogravimetry / differential thermal analysis).

Here, for the TG/DTA measurement, approximately 10 mg of the resin composition is precisely weighed, and measurement (atmosphere: nitrogen; rate of temperature rise: 5 degrees Celsius per minute) using a TG/DTA device (manufactured by Seiko Instruments) can be carried out.

Next, one mode of embodiment of the temporary bonding adhesive for a semiconductor wafer according to the present invention shall be explained.

[Temporary bonding adhesive for a semiconductor wafer]

The temporary bonding adhesive for a semiconductor wafer according to the present embodiment is a temporary bonding adhesive for a semiconductor wafer that temporarily bonds a semiconductor wafer to a supporting substrate for processing the semiconductor wafer, and that is used after treatment for detaching the semiconductor wafer from the supporting substrate by heating, containing a resin composition such that the difference between the 95% weight loss temperature and the 5% weight loss temperature is

$$5 \text{ degree Celsius} \leq (95\% \text{ weight loss temperature}) - (5\% \text{ weight loss temperature}) \leq 80 \text{ degrees Celsius.}$$

Since the temporary bonding adhesive for a semiconductor wafer having the above constitution contains a resin composition such that the difference between its 95% weight loss temperature and its 5% weight loss temperature is prescribed to be within the range 1 degree Celsius or more and 300 degrees Celsius or less, the temperature range needed for thermal decomposition of the temporary bonding adhesive will be narrow, so the time needed for thermal decomposition can be shortened, and damage to the semiconductor wafer can thereby be suppressed.
Additionally the effects of making the removal of the semiconductor wafer after treatment easy and making it so that the temporary bonding adhesive does not readily remain on the semiconductor wafer are achieved.
Additionally since a wide temperature region over which it can be used stably can be secured, it is possible to make it available for various processing steps while still temporarily bonded to the supporting substrate.
Additionally since it can be formed as a layer on a supporting substrate having a smooth surface and with a sufficient precision, it achieves the effect of having a high precision for processing such as grinding.
It is more preferable for the aforementioned resin composition to be such that the difference between the 95% weight loss temperature and the 5% weight loss temperature is

$$5 \text{ degree Celsius} \leq (95\% \text{ weight loss temperature}) - (5\% \text{ weight loss temperature}) \leq 80 \text{ degrees Celsius.}$$

By prescribing the difference between the 95% weight loss temperature and the 5% weight loss temperature of the aforementioned resin composition to be within such a range, the time needed for thermal decomposition can be shortened, and the effect of being able to secure a wide temperature region over which it can be used stably can be even more improved.
Here, "temperature region over which it can be used stably" refers to the temperature region over which a semiconductor wafer can be held stably without the temporary bonding adhesive breaking down. Since the temporary bonding adhesive according to the present embodiment can secure a wide region for this temperature region, it can be used for processing steps where heating is necessary, while the semiconductor wafer is still temporarily bonded to the supporting substrate. Whereby the advantage can be had of being able to carry out differing steps successively.
Additionally the aforementioned resin composition is preferably such that its 5% weight loss temperature is 50 degrees Celsius or greater. Whereby as explained below, the effect can be obtained of the temporary bonding adhesive not thermally decomposing during semiconductor device manufacturing processes such as a layer forming step, a bonding step, a processing step, or the like.
Additionally, said resin composition is preferably such that its 50% weight loss temperature is 500 degrees Celsius or less. Whereby as explained below, the effect can be obtained of preventing damage to the semiconductor device due to its heat history during the thermal decomposition step.
Here, the aforementioned resin composition such that the difference between its 95% weight loss temperature and its 5% weight loss temperature is prescribed to be within the range 1 degree Celsius or above and 300 degrees Celsius or below is not particularly restricted, but can be obtained by adjusting the molecular weight and the like of resins wherefor the bond strength of the main chain is low.
The aforementioned resin composition such that the difference between its 95% weight loss temperature and its 5% weight loss temperature can be prescribed to be within the range 1 degree Celsius or above and 300 degrees Celsius or below is not particularly restricted, but it may be, for example, a norbornene based resin, a polycarbonate based resin, a polyester based resin, a polyamide based resin, a polyimide based resin, a polyether based resin, a polyurethane based resin, a (meta) acrylate based resin, or the like. Additionally as described below, the thermal decomposition of the temporary bonding adhesive during semiconductor device manufacturing processes such as a layer

forming step, a bonding together step, a processing step, and the like, can be prevented, and further, the time for thermally decomposing the temporary bonding adhesive during the heating step can be shortened.
Among these resin compositions, norbornene based resins, or polycarbonate based resins are preferable, since they can effectively prevent thermal decomposition of the temporary bonding adhesive during semiconductor device manufacturing processes, and further, they can effectively shorten the thermal decomposition time for the temporary bonding adhesive during the heating step.

If the aforementioned resin composition is a norbornene based resin, it is preferable for the thermal decomposition time at the 50% weight loss temperature to be 1 minute or longer, and 120 minutes or shorter.
By making the thermal decomposition temperature higher than the minimum value given above, the rapid thermal decomposition of the temporary bonding adhesive can be suppressed, and since it will become possible to exhaust the thermally decomposed gas with an exhaust system, the contamination of the semiconductor device or the facility for manufacturing semiconductor devices can be prevented. Additionally, by making it lower than the maximum value given above, the time required for the thermal decomposition step can be shortened, so that the productivity of semiconductor devices can be improved.

Here, the aforementioned thermal decomposition time may be measured by the following method.
The 5% weight loss temperature is calculated using the method given above. Next, using a TG/DTA device, approximately 10 mg of the aforementioned resin composition is precisely weighed, and next, the temperature is raised from 25 degrees Celsius to the 5% weight loss temperature in 30 minutes, and further, the measurement temperature is maintained at the 5% weight loss temperature, and measurement is carried out. From the obtained measured values, the time at which the 5% weight loss temperature is reached is defined as the starting point (0 minutes), and the time required to reach the 95% weight loss temperature is defined as the aforementioned decomposition time.

In cases where the aforementioned resin composition is a polycarbonate based resin, it is preferable for the decomposition time at the 5% weight loss temperature to be 1 minute or longer, and 60 minutes or shorter.
By making the thermal decomposition temperature higher than the minimum value given above, the rapid thermal decomposition of the temporary bonding adhesive can be suppressed, and since it will become possible to exhaust the thermally decomposed gas with an exhaust device, so that contamination of the semiconductor device or the facility for manufacturing semiconductor devices can be prevented. Additionally by making it lower than the maximum value given above, the time required for the thermal decomposition step can be shortened, so that the productivity of semiconductor devices can be improved.

The aforementioned norbornene based resins are not particularly restricted, but as examples, resins which include structural units as shown in the General Formula (1) given below, can be given.

[Formula 1]

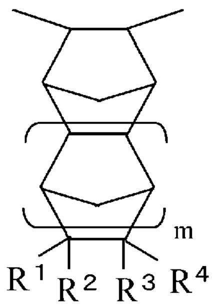

(1)

In Formula (1), $R^1$ to $R^4$ are each one of hydrogen, a linear or branched alkyl group having 1 to 20 carbon atoms, an aromatic group, an alicyclic group, a glycidyl ether group, or one of the substituent groups (2) given below. Additionally m is an integer from 0 to 4.

[Formula 2]

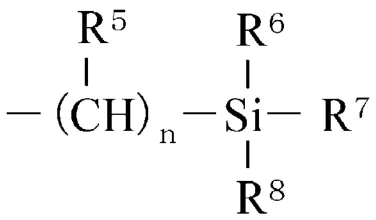

(2)

In Formula 2, $R^5$ is either a hydrogen group, a methyl group, or an ethyl group, and $R^6$, $R^7$, and $R^8$ are either a linear or branched alkyl group having 1 to 20 carbon atoms, a linear or branched alkoxy group having 1 to 20 carbon atoms, a linear or branched alkyl carbonyloxy group having 1 to 20 carbon atoms, a linear or branched alkyl peroxy group having 1 to 20 carbon atoms, or a substituted or non-substituted aryloxy group having 6 to 20 carbon atoms. Additionally n is an integer from 0 to 5.

The aforementioned linear or branched alkyl group having 1 to 20 carbon atoms is not particularly restricted, but for example, it may be a methyl group, an ethyl group, a propyl group, a butyl group, a pentyl group, a hexyl group, a heptyl group, an octyl group, a nonyl group, or a decyl group or the like.

Among these, a butyl groups or a decyl group, having an excellent compatibility with each type of component comprising the temporary bonding adhesive, or solubility with each type of solvent, or further, mechanical properties when a semiconductor wafer and a supporting substrate are temporarily bonded, is preferable.

The aforementioned aromatic group is not particularly restricted, but for example, it may be a phenyl group, a phenytyl group, a naphthyl group, or the like, but among these, a phenytyl group or a naphthyl group that has excellent mechanical properties when a semiconductor wafer and a supporting substrate are temporarily bonded, is preferable.

The aforementioned alicyclic group is not particularly restricted, but for example, it may be a trimer or the like such as a cyclohexyl group, a norbornenyl group, a dihydro dicyclopenta diethyl group, a tetracyclo dodecyl group, a methyl tetracyclo dodecyl group, a tetracyclo dodeca diethyl group, a dimethyl tetracyclo dodecyl group, an ethyl tetracyclo dodecyl group, an ethylidenyl tetracyclo dodecyl group, a phenyl tetracyclo dodecyl group, or a cyclopenta diethyl group. Among these, a cyclohexyl group, or a norbornenyl group, having excellent mechanical properties when a semiconductor wafer and a supporting substrate are temporarily bonded, and further, excellent thermal decomposability during the heating step, is preferable.

$R^5$ in the aforementioned substituent group (2) is not particularly restricted as long as it is a hydrogen atom, or a methyl group, or an ethyl group, but a hydrogen atom, having excellent thermal decomposability during heat treatment, is preferable.

$R^6$, $R^7$, and $R^8$ in the aforementioned substituent group (2) are not particularly restricted as long as they are each either a linear or branched alkyl group having 1 to 20 carbon atoms, a linear or branched alkoxy group having 1 to 20 carbon atoms, a linear or branched alkyl carbonyloxy group having 1 to 20 carbon atoms, a linear or branched alkyl peroxy group having 1 to 20 carbon atoms, or a substituted or non-substituted aryloxy group having 6 to 20 carbon atoms.

Such a substituent group may for example, be a methoxy group, an ethoxy group, a propoxy group, a butoxy group, a pentyloxy group, an acetoxy group, a propyoxy group, a gutyloxy group, a methylperoxy group, an isopropylperoxy group, a t-butylperoxy group, a phenoxy group, a hydroxyphenoxy group, a naphthyloxy group, a phenoxy group, a hydroxyphenoxy group, a naphthyloxy group or the like, and among these, a methoxy group, an ethoxy group, or a propoxy group, having excellent adhesiveness with the supporting substrate during temporary bonding, and excellent mechanical properties during semiconductor wafer processing, is preferable.

In the aforementioned General Formula (1), m is an integer from 0 to 4, and it is not particularly restricted, but it is preferably 0 or 1. If m is 0 or 1, then the structural unit shown in said General Formula (1) can be represented by General Formula (3) or (4) given below.

[Formula 3]

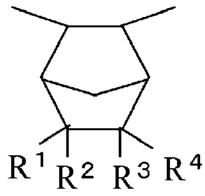

(3)

[Formula 4]

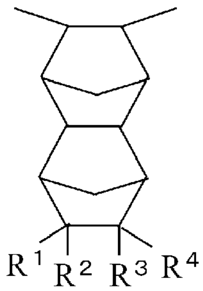

(4)

In the abovementioned Formulas (3) and (4), $R^1$ through $R^4$ are each either hydrogen, a linear or branched alkyl group having 1 to 20 carbon atoms, an aromatic group, an alicyclic group, a glycidyl ether group, or one of the substituent groups (2).

In the aforementioned substituent group (2), n is an integer from 0 to 5, and it is not particularly restricted, but it is preferable for n to be 0. If n is 0, the silyl group is directly bonded to the polycyclic ring via a silicon-carbon bond, so both heat decomposability of the temporary bonding adhesive and mechanical properties during semiconductor wafer processing can be achieved.

The structural unit designated by the aforementioned General Formula (1) is not particularly restricted, but it can be obtained by polymerizing norbornene based monomers such as norbornene, 5-methyl norbornene, 5-ethyl norbornene, 5-propyl norbornene, 5-butyl norbornene, 5-pentyl norbornene, 5-hexyl norbornene, 5-heptyl norbornene, 5-octyl norbornene, 5-nonyl norbornene, 5-decyl norbornene, 5-phenetyl norbornene, 5-triethoxy silyl norbornene, 5-trimethyl silyl norbornene, 5-trimethoxy silyl norbornene, 5-methyl dimethoxy silyl norbornene, 5-dimethyl methoxy norbornene, or 5-glicydyl oxymethyl norbornene.

When polymerizing the aforementioned norbornene based monomers, a single norbornene based monomer may be polymerized, or a plurality of norbornene based monomers may be copolymerized. Among these norbornene based monomers, 5-butyl norbornene, 5-decyl norbornene, 5-phenetyl norbornene, 5-triethoxy silyl norbornene, and 5-glicydyl oxymethyl norbornene, having excellent mechanical properties when a semiconductor wafer and a supporting substrate are temporarily bonded, are preferable.

The aforementioned norbornene based resins are not particularly restricted, and they may be formed with a single structural unit shown in said General Formula (1), or formed with a plurality of structural units.

More concrete examples of said norbornene based resins are homopolymers such as polynorbornene, polymethyl norbornene, polyethyl norbornene, polypropyl norbornene, polybutyl norbornene, polypentyl norbornene, polyhexyl norbornene, polyheptyl norbornene, polyoctyl norbornene, polynonyl norbornene, polydecyl norbornene, polyphenetyl norbornene, polytriethoxy silyl norbornene, polytrimethyl silyl norbornene, polytrimethoxy silyl norbornene, polymethyl dimethoxy silyl norbornene, polydimethyl methoxy silyl norbornene, or polyglycidyloxymethyl norbornene; or copolymers such as norbornene - triethoxysilyl norbornene copolymer, norbornene - glycidyloxy methyl norbornene copolymer, norbornene - glycidyloxy methyl norbornene copolymer, butyl norbornene - triethoxy silyl norbornene copolymer, decyl norbornene - triethoxy silyl norbornene copolymer, butyl norbornene - glycidyl oxymethyl norbornene copolymer, decyl norbornene - glycidyloxy methyl norbornene copolymer, or decyl norbornene - butylnorbornene - phenetyl norbornene - glycidyloxymethyl norbornene copolymer.

Among these, polybutyl norbornene, polydecyl norbornene, polytriethoxy silyl norbornene, polyglycidyl oxymethyl norbornene - butyl norbornene - triethoxysilyl norbornene copolymer, decyl norbornene - triethoxy silyl norbornene copolymer, butyl norbornene - glycidyloxy methyl norbornene copolymer, decyl norbornene - glycidyloxy methyl norbornene copolymer, and decyl norbornene - butyl norbornene - phenetyl norbornene - glycidyloxy methyl norbornene copolymer, having excellent mechanical properties when a semiconductor wafer and a supporting substrate are temporarily bonded, are preferable.

The weight average molecular weight of the aforementioned norbornene based resins is preferably from 10,000 to 1,000,000, and this is particularly preferably 30,000 to 800,000. By having the weight average molecular weight in the range given above, both the thermal decomposability of the temporary bonding adhesive and the heat resistance of the temporary bonding adhesive during semiconductor wafer processing can be achieved.

Here, the weight average molecular weight can be calculated as a polystyrene equivalent molecular weight by GPC (gel permeation chromatography) using THF as a solvent.

The norbornene based resin having the structural unit designated by the aforementioned General Formula (1) is not particularly restricted, but may be synthesized by ring opening metathesis polymerization (herebelow also referred to as "ROMP"), a combination of ROMP and hydrogenation reaction, or radical polymerization or cationic polymerization.

As a synthesis method for the norbornene based resin having the structural unit designated by said General Formula (1), for example, synthesis can be carried out using a catalyst containing a palladium ion source, a catalyst containing nickel and platinum, or a radical initiator, or the like.

The aforementioned catalyst containing a palladium ion source is not particularly restricted, the compounds designated by the following General Formula (5) can be given.

[Formula 5]

$$[L_nPdX_m] \quad [CA]_a \qquad (5)$$

In Formula (5), L is a ligand containing 1, 2, or 3 pi bonds, and X is a ligand containing 1 sigma bond and 0 to 3 pi bonds. n is an integer from 0 to 2, and m is either 0 or 1. m and n are never simultaneously 0, and additionally when m is 0, a is 2, and when m is 1, a is 1. CA is a weakly coordinating counterion.

The "weakly coordinating counterion" in said General Formula (5) refers to an anion that is easily substituted by a neutral Lewis base due to being weakly coordinated with a cation.

The ligand L in the aforementioned General Formula (5) is a ligand that is weakly coordinated to a palladium cation complex. Since this ligand L is relatively inactive, by reducing the ligand L, it can be easily removed from a cation complex by introducing a monomer into a growing polymer chain.

The ligand L is not particularly restricted, but examples are mono-olefins having 2 to 12 carbon atoms (e.g., 2,3-dimethyl-2-butane), di-olefins having 4 to 12 carbon atoms (e.g., norbornadiene), or aromatic groups having 6 to 20 carbon atoms, and preferably the ligand L may be a chelated 2-position coordinating cyclic diolefin having 6 to 12 carbon atoms, for example, cyclo-octadiene (herebelow, also referred to as "COD"), dibenzo-COD, or an aromatic compound such as benzene, toluene, or mesitylene.

Additionally the ligand X in the aforementioned General Formula (5) is not particularly restricted, but may be selected from (i) a group wherein a single carbon-metal sigma bond (not a pi bond) is imparted to a palladium in a cation complex, or (ii) a group wherein a single metal-carbon sigma bond and 1 to 3 pi bonds are imparted to a palladium in a cation complex.

Regarding the aforementioned group (i) of ligand X, this group is bonded to the palladium with a single metal-carbon sigma bond and a non-pi bond, and it is not particularly restricted, but for example it may be a methyl group, an ethyl group, a linear or branched chain propyl group, a butyl group, a pentyl group, a neopentyl group, a hexyl group, a heptyl group, an octyl group, a nonyl group, a decyl group, an aralkyl group with 7 to 15 carbon atoms, a benzyl group, or the like.

Regarding the aforementioned group (ii), the cation has a hydrocarbyl group that is directly bonded to the palladium by a single metal-carbon sigma bond, and similarly by at least 1 and not more than 3 pi bonds. By means of the hydrocarbyl group, by imparting a carbon-metal sigma bond and 1 to 3 olefinic pi bonds that may be conjugated or non-conjugated, the palladium metal cation complex can be stabilized.

Regarding the aforementioned group (ii), the hydrocarbyl group is not particularly restricted, but it may be a non-cyclic, monocyclic, polycyclic, linear or branched chain alkoxy group having 1 to 20 carbon atoms, an aryloxy group having 6 to 15 carbon atoms, or an alkynyl group having 3 to 20 carbon atoms that may be substituted with a halo group

(e.g., Cl and F).

It is preferable for the ligand X in the aforementioned General Formula (5) to be a single aryl ligand that has a single sigma bond and a single pi bond, or a cationic form thereof, or alternatively a compound that imparts at least one olefinic pi bond to a metal, and a single sigma bond to a metal from a distant carbon atom that is separated from both olefinic carbon atoms, by at least 2 carbon-carbon single bonds (iii).

In cases where there is no ligand L or X (that is, if n or m is 0), the palladium cation complex is weakly coordinated by the solvent with which the reaction is carried out. The aforementioned solvent is not particularly restricted, but halogenated hydrocarbons such as carbon tetrachloride, chloroform, dichloromethane, 1,2- dichloromethane, and aromatic hydrocarbons such as benzene, toluene, mesitylene, chlorobenzene, and nitrobenzene may be given as examples.

Next, a mode of the palladium cation complex of the single component catalysis system of the present invention is given below. Formula (6) below shows a mode wherein said ligand X of (i) is a methyl group that is bonded to a palladium atom through a single metal-carbon sigma bond, and the ligand L is a COD that is weakly coordinated to a palladium metal through two olefinic pi bonds.

[Formula 6]

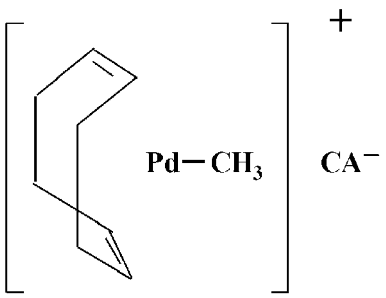

(6)

The Formulas (7), (8), and (9) given below show modes of the aforementioned (ii) that are directly bonded to palladium by a single metal-carbon sigma bond, and similarly at least one, and not more than 3, pi bonds.

[Formula 7]

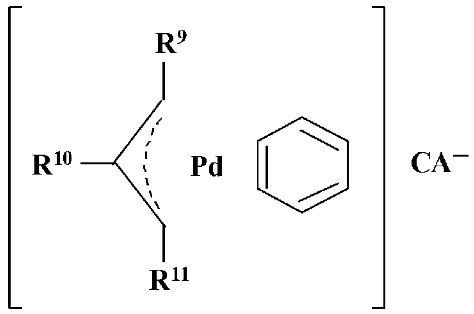

(7)

[Formula 8]

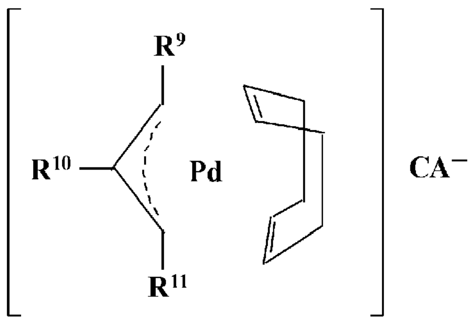

(8)

In Formulas (7) and (8), $R^9$, $R^{10}$, and $R^{11}$ are each either a hydrogen, a linear or branched chain alkyl group having 1 to 5 carbon atoms, an aryl group having 6 to 14 carbon atoms, or an alicyclic group having 5 to 6 carbon atoms.

[Formula 9]

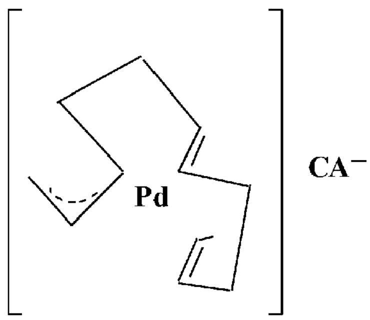

(9)

Formula (7) given above shows a mode wherein L does not exist, but an aromatic group that imparts three pi bonds is weakly coordinated to the palladium metal, and additionally X is an aryl group that imparts a single metal-carbon sigma bond and an olefinic pi bond with the palladium.

Formula (8) given above shows a mode wherein L is a COD, and X is an aryl group that imparts a single metal-carbon sigma bond and an olefinic pi bond with the palladium.

Formula (9) given above shows a mode wherein X is an unsaturated hydrocarbon group that imparts an o-metal-carbon sigma bond, one conjugate pi bond, and two adduct pi bonds with the palladium.

Formula (10) and (11) given below show modes wherein (iii) L is a COD, X is a ligand that imparts at least one olefinic pi bond to a palladium metal, and a single sigma bond to a metal from a distant carbon atom that is separated from, with space in between, both olefinic carbon atoms, by at least 2 carbon-carbon single bonds.

[Formula 10]

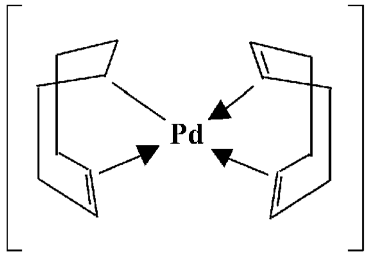

CA⁻ (10)

[Formula 11]

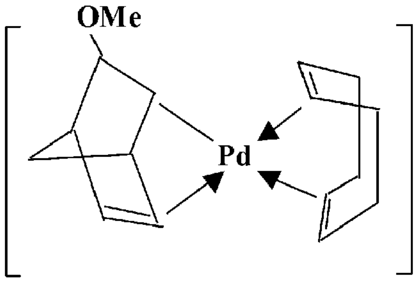

CA⁻ (11)

The palladium cation complex described above associates with a relatively inactive, weakly coordinating or non-coordinating, counteranion CA weakly nucleophilic agent, and becomes a cation complex that is soluble in a solvent. The design of the anion species must be such that it is stable relative to reactions with the cationic palladium complex in the catalysis species, it is inactive, and it is soluble in the solvent.

The aforementioned anion is not particularly restricted, but tetrafluorides of Ga, Al, B; hexafluorides of P, Sb, and As; perfluoro-acetate; propionate; butyrate; hydrated perchlorate; toluene sulfonate; trifluoromethylsulfonate; and substituted tetraphenylborate wherein the phenyl ring is substituted with fluoride or a trifluoromethyl group may be given as examples.

The aforementioned counterion is not particularly restricted, but $BF_4$-, $PF_6$-, $AlF_3O_3SCF_3$-, $SbF_6$-, $SbF_5SO_3F$-, $AsF_6$-, trifluoro acetate ($CF_3CO_2$-), pentafluoro propionate ($C_2F_5CO_2$-), heptafluoro butyrate ($CF_3CF_2CF_2CO_2$-), perchlorate ($ClO_4$-•$H_2O$), p- toluene- sulfonate (p-$CH_3C_6H_4SO_3$-), and the compounds shown in the Formula (12) given below can be given as examples.

[Formula 12]

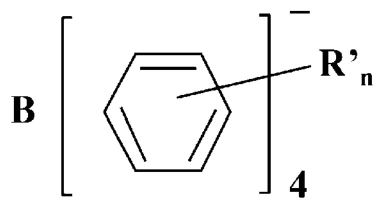
(1 2)

In Formula (12), R' is either hydrogen, fluoride, or tricluoromethyl, and n is 1 through 5.

As said catalyst containing a palladium ion source, the compound shown in the following Formula (13) is preferable.

[Formula 13]

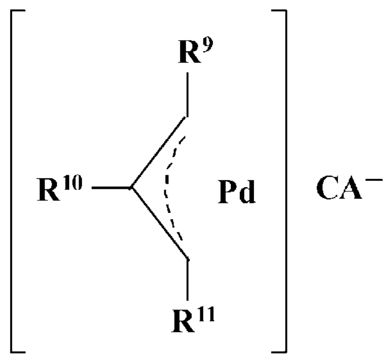
(1 3)

The compound shown in the aforementioned Formula (13) comprises a weakly coordinating counteranion and a pi-aryl palladium complex, and is a compound having an arylic functionality, wherein the aryl group of the cation complex is bonded by a single carbon-palladium sigma bond and an olefinic pi bond.

As is the case with the compound shown in the aforementioned Formula (13), a catalyst wherein the palladium metal of the cation complex lacks any ligand other than aryl functionality that is, one that contains a palladium ion source where Ln=0, shows excellent activity during the polymerization of a norbornene based resin.

In the aforementioned General Formulas (7), (8), and (13), any two of R9, $R^{10}$, and $R^{11}$ may be bonded together, and may form a cyclic, or a polycyclic structure.

The polycyclic structure is not particularly restricted, but may for example, be a carbon ring, or a heterocyclic ring. It is preferable for any two of R9, $R^{10}$, and $R^{11}$ to bond together and form a ring having 5 to 20 atoms. Here, the atoms forming heterocyclic rings are not particularly restricted, but they may for example, be nitrogen, sulfur, or the like.

As the aforementioned cyclic group having aryl functionality, it is not particularly restricted, but for example, the compound shown in Formula (14) below can be given.

[Formula 14]

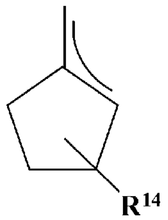
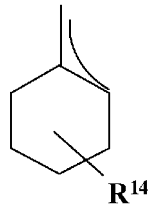
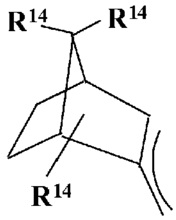
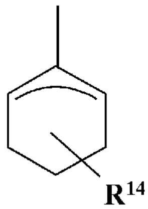
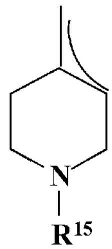
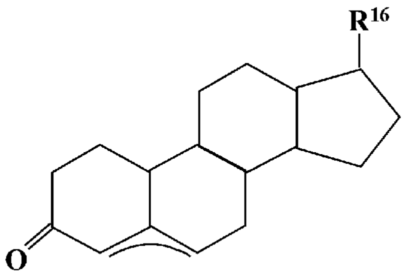
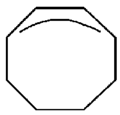

(14)

In Formula (14), $R^{14}$ is hydrogen, or a linear or branched chain alkyl group having 1 to 5 carbon atoms, $R^{15}$ is a methylcarbonyl group, and $R^{16}$ is a linear or branched chain alkyl group having 1 to 20 carbon atoms.

Additionally as a catalyst during the synthesis of a norbornene based resin, a multicomponent-based catalyst, that contains one or both of a palladium ion source and an organic aluminum compound, and a third component, may be used.

The aforementioned palladium ion source is not particularly restricted, and may be selected from compounds containing palladium, but the compounds containing palladium are preferably soluble in the reaction medium.

The aforementioned compound containing palladium comprises an ionic and/or neutral ligand that is bonded to a palladium metal. The ionic and neutral ligand may be selected from various types of monodentate ligands, bidentate ligands, or molecular fragments of multidentate ligands, and combinations thereof.

The ionic ligands that bond to palladium and generate compounds containing palladium are not particularly restricted, but they may be, for example, anionic ligands such as halides such as chloride, bromide, iodide, and fluoride ions; pseudohalides such as cyanide, cyanate, thiocyanate, hydrides and the like; branched and non-branched alkyl anions having 1 to 40 carbon atoms, carbanions such as phenyl anions and the like; cyclopentadienylide anions; pi aryl groups; halogenized acetyl acetates such as acetyl acetate, 2,4-pentanedionate, 1,1,1,5,5,5- hexafluoro- 2,4- pentanedionate, 1,1,1- trifluoro-2,4- pentanedionate; acidic oxides of carbon such as carboxylates and halogenized carboxylates (for example, acetate, 2-ethyl hexanoate, neodecanoate, trifluoroacetate); anions of oxides of nitrogen (e.g., nitrates and nitrites), bismuth (e.g., bismuthates), aluminum (e.g., aluminates), silicon (e.g., silicates), phosphorus (e.g., phosphates, phosphates, and phosphines), and sulfur (e.g., triflates, p-toluene sulfonates, and sulfites); irides; amides; imides; oxides; phosphides; sulfides; aryl oxides with 6 to 24 carbon atoms, alkoxides with 1 to 20 carbon atoms, hydroxides, alkyls of hydroxys with 1 to 20 carbon atoms, catechols, oxarates, chelated alkoxides and aryloxides.

The aforementioned compound containing palladium may contain a complex anion such as $PF_6$-, $AlF_3O_3SCF_3$-, $SbF_6$-, and the compound shown in Formula (15) below.

[Formula 15]

$$Al(R'')^{-}_{4} 、 B(X)^{-}_{4} \quad (15)$$

In Formula (15), R" and X are independently a halogen atom selected from among Cl, F, I, and Br, or a substituted or non-substituted hydrocarbyl group.

The aforementioned hydrocarbyl group is not particularly restricted, but for example, it may be a methyl group,

an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a heneicosyl group, a docosyl group, a tricosyl group, a tetracosyl group, a pentacosyl group, and isomers thereof that are alkyl groups having 1 to 25 carbon atoms; a vinyl group, an aryl group, a crotyl group, a butenyl group, a pentenyl group, a hexexyl group, an octenyl group, a nonenyl group, a decenyl group, an undecenyl group, a dodecenyl group, a tridecenyl group, a tetradecenyl group, a pentadecenyl group, a hexadecenyl group, a pentadecenyl group, a hexadecenyl group, a heptadecenyl group, an octadecenyl group, a nonadecenyl group, a pentacocenyl group, and isomers thereof that are alkenyl groups having 2 to 25 carbon atoms; an aryl group having 6 to 25 carbon atoms such as a phenyl group, a tolyl group, a xylyl group, or a naphthyl group; an aralkyl group having 7 to 25 carbon atoms such as a benzyl group, a phenetyl group, a phenpropyl group, a phenbutyl group, a phenhexyl group, or a naphthoctyl group; or a cycloalkyl group having 3 to 8 carbon atoms, such as a cyclopropyl group, a cyclobutyl group, a cyclopentyl group, a cyclohexyl group, a cycloheptyl group, a cyclooctyl group, a 2-norbornyl group, or a 2-norbornyl group.

In the aforementioned Formula (15), X includes the groups shown below in Formula (16).

[Formula 16]

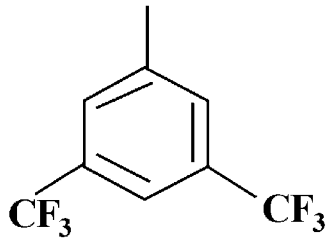

(16)

Here, the "substituted hydrocarbyl group" refers to one where one or more hydrogen atoms are substituted with a halogen atom such as Cl, F, Br, and I (e.g., as in perfluorophenyl groups); a hydroxyl; an amino; an alkyl; a nitro; a mercapto, or the like.

The aforementioned compound containing palladium is not particularly restricted, but it may contain, for example, organic ammonium, organic arsonium, organic phosphonium, and a cation such as the pyridium compounds shown in Formula (17) below.

[Formula 17]

$$A^+(R^{17})_4$$

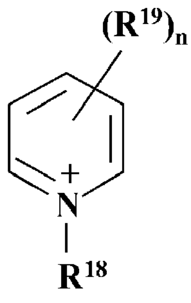

(17)

In Formula (17), A represents nitrogen, arsenic, and phosphorus, and $R^{17}$ is selected from among hydrogen, a branched or unbranched alkyl group having 1 to 20 carbon atoms, a branched or unbranched alkenyl group having 2 to 20 carbon atoms, and, for example, a cycloalkyl having 5 to 16 carbon atoms such as cyclopentyl, cyclohexyl, cycloheptyl, cyclooctyl, and the like. $R^{18}$ and $R^{19}$ are selected from hydrogen, a branched or unbranched alkyl group having 1 to 50 carbon atoms, a branched or unbranched alkenyl group having 2 to 50 carbon atoms, and a cycloalkyl group having 5 to 15 carbon atoms. Additionally n is an integer from 1 to 5.

It is preferable for $R^{17}$ in the aforementioned Formula (17) to be an alkyl group wherefor the solubility in an

organic solvent improves, having 15 to 72 carbon atoms, preferably 25 to 48 carbon atoms, and even more preferably 21 to 42 carbon atoms.

It is preferable for $R^{18}$ in the aforementioned Formula (17) to be a branched or unbranched alkyl group having 1 to 50 carbon atoms, and more preferable for it to be an alkyl group having 10 to 40 carbon atoms.

It is preferable for $R^{19}$ in the aforementioned Formula (17) to be a branched or unbranched alkyl group having 1 to 40 carbon atoms, and more preferable for it to be an alkyl group having 2 to 30 carbon atoms.

The aforementioned organic ammonium cation is not particularly restricted, but it may be, for example, tridecyl ammonium, methyltricapryl ammonium, tris (tridecyl) ammonium, or trioctyl ammonium, or the like.

The aforementioned organic arsonium or organic phosphonium cation is not particularly restricted, but it may be, for example, tridecyl arsonium and phosphonium, methyltricapryl arsonium and phosphonium, tris (tridecyl) arsonium and phosphonium, or trioctyl arsonium and phosphonium, or the like.

The aforementioned pyridinium cation is not particularly restricted, but it may be, for example, eicosyl-4-(1-butyl pentyl) pyridinium, docosyl-4-(13-pentacosyl) pyridinium and eicosyl-4-(1-butyl pentyl) pyridinium, or the like.

The neutral ligand that bonds with palladium is not particularly restricted, but it may be, for example, an olefin; an acetylene; carbon monoxide; a nitrogen compound such as an oxide of nitrogen, ammonium, alkyl isocyanide, alkyl isocyanate, or alkyl isothiocyanate; pyridine and pyridine derivatives (e.g., 1,10-phenanthroline, 2,2'-dipyridyl), 1,4-dialkyl-1,3-diazabutadiene, 1,4-diaryl+ diazabutadiene, or the compounds shown in Formula (18) given below.

[Formula 18]

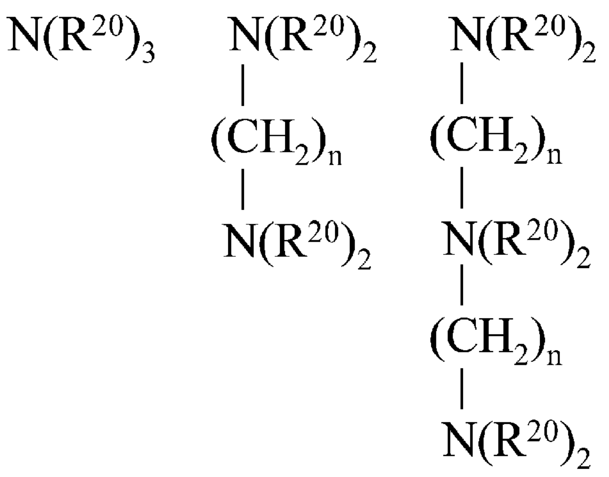

(1 8)

Here, $R^{20}$ is a hydrocarbyl group or a substituted hydrocarbyl group, and n is an integer from 2 to 10.

The compound shown in the aforementioned Formula (18) is not particularly restricted, but for example, it may be an amine; a urea; a nitrile such as acetonitrile, penzonitrile, and halogenized derivatives thereof; organic ethers such as cyclic ethers such as dimethyl ether of diethylene glycol, dioxane, tetrahydrofuran, furan diaryl ether, diethyl ether, diethylene glycol cyclic oligomers; organic sulfides such as thioethers; arsines; stibines; phosphines such as triaryl phosphine, trialkyl phosphine, bis (diphenyl phosphino) ethane, bis (diphenyl phosphino) propane, bis (dimethylp hosphino) propane, bis (diphenyl phosphino) butane, (S)- (-) 2,2'- bis (diphenyl phosphino)- 1,1'- binaphthyl, (R)-(+)- 2,2'-bis (diphenyl phosphino)-1,1- binaphthyl, and bis (2- diphenyl phosphino ethyl) phenylphosphine; phosphine oxides; phosphorus halides, and the compounds shown in Formula (19) given below.

[Formula 19]

$$P(OR^{20})_3 \quad (19)$$

Here, $R^{20}$ represents a hydrocarbyl group or a substituted hydrocarbyl group; a phosphorus oxyhalide; a phosphonate; a phosphonite; a phosphinite; a ketone; or a sulfoxide such as an alkylsulfonide having 1 to 20 carbon atoms, an arylsulfoxide having 6 to 20 carbon atoms, or an alkaryl sulfonide having 7 to 40 carbon atoms.

The abovementioned palladium source is not particularly restricted, but it may be, for example, palladium ethyl hexanoate, trans-PdCl2(PPh3)2, palladium (II) bis (trifluoroacetate), palladium (II) bis (acetylacetonate), palladium (II) 2-ethyl hexanoate, Pd (acetate)2 (PPh3)2, palladium (II) bromide, palladium (II) chloride, palladium (II) iodide, palladium (II) oxide, monoacetonitrile tris (triphenyl phosphine) palladium (II) tetrafluoro borate, tetrakis (acetonitrile) palladium (II) tetrafluoro borate, dichloro bis (acetonitrile) palladium (II), dichloro bis (triphenyl phosphine) palladium (II), dichloro bis (benzonitrile) palladium (II), palladium acetyl acetonate, palladium bis (acetonitrile) dichloride, palladium bis (dimethyl sulfonide) dichloride, or the like.

The aforementioned organic aluminum compound is not particularly restricted, but may be, for example, the compound shown in Formula (20) below.

[Formula 20]

$$Al(R^{21})_{3-x}Q_x \quad (20)$$

Here, $R^{21}$ represents a branched or unbranched alkyl group having 1 to 20 carbon atoms, an aryl group having 6 to 24 carbon atoms, an aralkyl group having 7 to 20 carbon atoms, or a cycloalkyl having 3 to 10 carbon atoms, Q is a halide or a pseudohalide such as chlorine, fluorine, bromine, iodine, a branched or unbranched alkoxy having 1 to 20 carbon atoms, or an aryloxy, and x is 0 to 2.5.

The aforementioned aluminum compound is not particularly restricted, but it may be, for example, a trialkyl aluminum such as trimethyl aluminum, triethyl aluminum, tripropyl aluminum, triisopropyl aluminum, triisobutyl aluminum, tri-2-methyl butyl aluminum, tri-3-methyl butyl aluminum, tri-2-methyl pentyl aluminum, tri-3-methyl pentyl aluminum, tri-4-methyl pentyl aluminum, tri-2-methyl hexyl aluminum, tri-3-methyl hexyl aluminum, trioctyl aluminum, or tris-2-norbornyl aluminum; or a dialkyl aluminum halide such as dimethyl aluminum chloride, diethyl aluminum chloride, diisopropyl aluminum chloride, or diisobutyl aluminum chloride; a monoalkyl aluminum dihalide such as methyl aluminum dichloride, ethyl aluminum dichloride, ethyl aluminum diiodide, propyl aluminum dichloride, isopropyl aluminum dichloride, butyl aluminum dichloride, or isobutyl aluminum dichloride; or an alkyl aluminum sesquihalide such as methyl aluminum sesquichloride, ethyl aluminum sesquichloride, propyl aluminum sesquichloride, or isobutyl aluminum sesquichloride.

For the aforementioned solvents containing palladium ion sources, organic aluminum compounds, third component compounds, and compounds that comprise mixtures thereof may be used.

The aforementioned third component compound is not particularly restricted, but it may be, for example, Lewis acids such as $BF_3$·etherate, $TiCl_4$, $SbF_5$, tris (perfluorophenyl) boron, $BCl_3$, or $B(OCH_2CH_3)_3$; strong Bronsted acids such as hexafluoro antimonite ($HSbF_6$), $HPF_6$ hydrate, trifluoro acetate ($CF_3CO_2H$), $FSO_3H$-$SbF_6$, $H_2C(SO_2CF_3)_2CF_3SO_3H$, or para toluene sulfonate; hexachloro acetone, hexafluoro acetone, 3-butenate-2,2,3,4,4-pentachloro butyl ester, hexafluoro glutarate, hexafluoro isopropanol, or chloranil; electron donating compounds such as phosphines and phosphites; aliphatic compounds having 4 to 12 carbon atoms, such as butadiene, cyclooctadiene, and norbornadiene; and olefinic electron donating compounds such as alicyclic diolefin having 6 to 12 carbon atoms.

The method for using the aforementioned multi-component based catalyst, is not particularly restricted, but a compound containing palladium, an organic aluminum compound, and a third component my be blended together in a hydrocarbon or a halo-hydrocarbon solvent, and next, this preliminary mixed catalyst system can be mixed into a reaction solvent comprising at least one norbornene based monomer, thereby polymerizing a norbornene based resin.

The aforementioned reaction using a catalyst may be carried out in an organic solvent that does not act on the catalyst, and additionally can dissolve the norbornene based monomer. The aforementioned organic solvent is not

particularly restricted, but it may be, for example, an aliphatic hydrocarbon such as pentane, hexane, heptane, octane, or decane; an alicyclic hydrocarbon such as cyclopentane or cyclohexane; aromatic hydrocarbons such as benzene, chlorobenzene, nitrobenzene, toluene, and xylene; or a halogenized (polar) hydrocarbon such as methylene chloride, chloroform, carbon tetrachloride, ethyl chloride, 1,1- dichloroethane, 1,2- dichloroethane, 1,2- dichloroethylene, 1-chloropropane, 2- chloropropane, 1- chlorobutane, 2- chlorobutane, 1- chloro- 2-methyl propane, or 1- chloropentane. For the single component catalyst system of the present invention, cyclohexanone or ethyl acetate may be similarly utilized. The selection of the reaction solvent is done based upon a large number of factors, including the selection of the catalyst, and whether it is desirable to carry out the polymerization with a slurry method or a solution method. Solvents that are preferable for a large proportion of the catalysts described for the present invention are chlorinated hydrocarbons such as methylene chloride or 1,2- dichloroethane, and aromatic hydrocarbons such as chlorobenzene and nitrobenzene.

The mole ratio of the aforementioned norbornene based monomer to the catalyst containing palladium is preferably from 20:1 to 100,00:1, more preferably 200:1 to 20,000:1, and still more preferably 1,000:1 to 10,000:1.

In the aforementioned multi component catalyst, it is preferable that the mole ratio of the compound containing palladium to the organic aluminum compound is such that there is less of the aluminum compound than 100:1, and it is more preferable for it to be such that there is less of the aluminum compound than 30:1, and it is still more preferable for it to be such that there is less of the aluminum compound than 20:1.

Regarding the aforementioned multi-component catalyst, the mole ratio of the compound containing palladium to the third component may be within the range 0.25:1 to 20:1. If an acid is used for the aforementioned third component, it is preferable for there to be less of the acid than 4:1, and it is still more preferable for there to be less of the acid than 2:1.

When polymerizing the aforementioned norbornene based monomer with the palladium catalyst, the polymerization temperature is preferably -100 to 120 degrees Celsius, and more preferably -60 to 90 degrees Celsius, and still more preferably -10 to 80 degrees Celsius.

The aforementioned catalyst containing nickel and platinum is not particularly restricted, but the ones described in WO1997/033198 and WO2000/020472 may be used.

The aforementioned catalyst containing nickel and platinum may be, for example, the compounds shown in the following Formula (21).

[Formula 21]

$$En' \, Ni(C_6F_5)_2 \qquad (21)$$

(Here, n' designates 1 or 2, and E designates a 2 electron donating ligand)

When n in the aforementioned Formula (21) is such that n=1, E is preferably a pyrene ligand, such as toluene, benzene, or mesitylene. If n=2, E is preferably selected from among THF (tetrahydrofuran), ethyl acetate (EtOAc), and dioxane.

The aforementioned catalyst containing nickel and platinum is not particularly restricted, but for example, it may be (toluene) bis (perfluorophenyl) nickel, (methylene) bis (perfluorophenyl) nickel, (benzene) bis (perfluorophenyl) nickel, bis (tetrahydro) bis (perfluorophenyl) nickel, bis (ethyl acetate) bis (perfluorophenyl) nickel, or bis (dioxane) bis (perfluorophenyl) nickel.

The mole ration of the aforementioned norbornene based monomer to the catalyst containing nickel and platinum is preferably from 20:1 to 100,00:1, more preferably 200:1 to 20,000:1, and still more preferably 1,000:1 to 10,000:1.

When carrying out polymerization with the aforementioned norbornene based monomer and the catalyst containing nickel and platinum, the polymerization temperature is preferably 0 to 70 degrees Celsius, more preferably 10 to 50 degrees Celsius, and still more preferably 20 to 40 degrees Celsius.

The aforementioned radical initiator is not particularly restricted, but one described in the Encyclopedia of Polymer Science, John Wiley and Sons, 13708 (1988) may be used.

Examples of the aforementioned radical initiator are azobisisobutyronitrile (AIBN), benzoyl peroxide, lauryl peroxide, azobis isocapronitrile, azobis isovaleronitrile, and t-butyl hydrogen peroxide, and the like.

When polymerizing the aforementioned norbornene based monomer with a radical initiator, the polymerization temperature thereof is preferably 50 to 150 degrees Celsius, more preferably 60 to 140 degrees Celsius, and still more preferably 70 to 130 degrees Celsius.

The aforementioned polycarbonate based resin is not particularly restricted, but it may be, for example, polypropylene carbonate, polyethylene carbonate, 1,2- polybutylene carbonate, 1,3- polybutylene carbonate, 1,4-polybutylene carbonate, cis- 2,3- polybutylene carbonate, trans- 2,3 -polybutylene carbonate, α,β- polyisobutylene carbonate,

α,γ- polyisobutylene carbonate, cis- 1,2- polycyclobutylene carbonate, trans- 1,2- polycyclobutylene carbonate, cis- 1,3- polycyclobutylene carbonate, trans- 1,3- polycyclobutylene carbonate, polyhexene carbonate, polycyclopropene carbonate, polycyclohexene carbonate, poly (methylcyclohexene carbonate), poly (vinyl cyclohexene carbonate), polydihydro naphthalene carbonate, polyhexahydro styrene carbonate, polycyclohexane propylene carbonate, polystyrene carbonate, poly (3-phenyl propylene carbonate), poly(3-trimethyl silyloxypropylene carbonate), poly (3- methacryloyloxy propylene carbonate), polyperfluoro propylene carbonate, polynorbornene carbonate, or a combination thereof.

More concrete examples of the aforementioned polycarbonate based resins are polypropylene carbonate / polycyclohexene carbonate copolymer, poly [(oxy carbonyl oxy- 1,1,4,4- tetramethyl butane)- alt- (oxycarbonyl oxy- 5-norbornene- 2- endo- 3- endo- dimethane)], poly [(oxy carbonyl oxy- 1,4-dimethyl butane)- alt- (oxy carbonyl oxy- 5-norbornene- 2- endo- 3- endo-dimethane)], poly [(oxy carbonyl oxy- 1,1,4,4- tetramethyl butane)- alt- (oxy carbonyl oxy-p- xylene)], and poly [(oxy carbonyl oxy- 1,4- dimethyl butane)-alto- (oxy carbonyl oxy- p- xylene)].

It is preferable for the weight average molecular weight (Mw) of the aforementioned polycarbonate to be 1,000 to 1,000,00, and more preferable for it to be 5,000 to 800,000.

By making the aforementioned weight average molecular weight be above the abovementioned lower limit, the wettability of the temporary bonding adhesive to the semiconductor wafer or supporting body during the layer forming step can be improved, and further, the effect of improved film formability can be obtained. Additionally by making it lower than the aforementioned upper limit, the compatibility with each of the components comprising the temporary bonding adhesive, and the solubility in various types of solvents, and further, the effect of improved thermal decomposability of the temporary bonding adhesive during the heating step can be obtained.

The method for polymerizing the aforementioned polycarbonate based resin is not particularly restricted, but publicly known polymerization methods such as, for example, the phosgene method (solvent method) or the ester exchange method (melting method), may be used.

The aforementioned resin compositions are preferably blended in so that their proportion is 10% to 100% of the entire amount of the temporary bonding adhesive. More preferably they should be blended in so that their proportion is 30% to 100%. This is because, by making the contained amount of the resin composition higher than the aforementioned lower limit, the existence of residual temporary bonding adhesive on the semiconductor wafer or the supporting body after the detachment step described below, can be prevented.

As the aforementioned resin compositions, particularly preferable are polypropylene carbonate, 1,4-polybutylene carbonate, butyl norbornene-triethoxysilyl norbornene copolymer, decylnorbornene- butylnorbornene-phenetyl norbornene- glycidyl oxymethyl norbornene copolymer, and decyl norbornene- glycidyl oxymethyl norbornene copolymer.

Additionally the aforementioned temporary bonding adhesive may contain a solvent. The solvent is not particularly restricted, but it may be a hydrocarbon such as mesitylene, decalin, and mineral spirits; an alcohol or an ether such as anisole, propylene glycol monomethyl ether, dipropylene glycol methyl ether, diethylene glycol monoethyl ether, and diglyme; an ester or a lactone such as ethylene carbonate, ethyl acetate, N-butyl acetate, ethyl lactate, 3-ethoxypropionate ethyl, propylene glycol monomethyl ether acetate, diethylene glycol monoethyl ether acetate, propylene carbonate, and γ-butyrolactone; a ketone such as cyclopentanone, cyclohexanone, methyl isobutyl ketone, and 2-heptanone; or an amide or a lactam such as N- methyl- 2-pyroridinone. Because the temporary bonding adhesive contains a solvent, the viscosity of the temporary can be readily adjusted, and it becomes easy to form a layer of the temporary bonding adhesive on a semiconductor wafer or a supporting substrate.

The contained amount of the aforementioned solvent is not particularly restricted, but it is preferably 5 to 98 wt%, and more preferably 10 to 95 wt%.

The aforementioned temporary bonding adhesive may contain a photo initiator. The photo initiator is not particularly restricted, but it may be, for example, a photo radical initiator or a photo acid generating agent. If the resin composition contains a photo initiator, a resin composition can be formed at a desired position, by having an exposing and developing step.

The aforementioned photo radical initiator is not particularly restricted, as long as it is a compound that it breaks down into two types of compounds or more by being irradiated with actinic rays, and at least one of the aforementioned compounds is a compound having free radicals, for example, bis (2,4,6- trimethyl benzoyl)- phenyl phosphin oxide (Irgacure 819, Ciba Specialty Chemicals Inc.), 2- benzyl- 2- dimethyl amino- 1- (4-morpholinophenyl)- butanone-1 (Irgacure 369, Ciba), 2,2- dimethoxy- 1,2-diphenyl ethane- 1- one (Irgacure 651, Ciba), 2-methyl- 1 [4- (methylthio)-phenyl]-2- morpholinopropane- 1- one (Irgacure 907, Ciba), benzoin ethyl ether (BEE, Aldrich), 2- methyl- 4'- (methylthio)- 2-morpholino- propiophenone, 2,2'-dimethoxy- 2- phenyl- acetophenone (Irgacure 1300, Ciba), 2,6- bis (4-azidobenzylidene)- 4- ethyl cyclohexane (BAC-E), or the like.

The aforementioned photo acid generating agent is not particularly restricted, as long as it is a compound that generates acid when irradiated with actinic rays, for example, nuclophilic halides, complex metal halide anions, or the like. More concrete examples are tetrakis (pentafluorophenyl) borate- 4-methylphenyl [4- (1-methyl ethyl) phenyl] iodonium (DPI-TPFPB), tris (4- t-butyl phenyl) sulfonium tetrakis- (pentafluoro phenyl) borate (TTBPS-TPFPB), tris (4-t- butyl phenyl) sulfonium hexafluoro phosphate (TTBPS-HFP), triphenyl sulfonium trifurate (TPS-Tf), bis (4- tert- butyl phenyl)

iodonium trifurate (DTBPI-Tf), triazine (TAZ-101), triphenyl sulfonium hexafluoro antimonite (TPS-103), triphenyl sulfonium bis (perfluoro methane sulfonyl) imide (TPS-N1), di- (p- t- butyl) phenyl iodonium, bis (perfluoromethand sulfonyl) imide (DTBPI-N1), triphenyl sulfonium, tris (perfluoromethane sulfonyl) methide (TPS-C1), di- (p- t- butyl phenyl) iodonium tris (percluoromethande sulfonyl) methide (DTBPI-C1), or the like.

The contained amount of the aforementioned photo initiator, relative to 100 weight portions of the aforementioned resin composition, is preferably 0.1 to 10 weight portions, and more preferably 0.5 to 5 weight portions.

The aforementioned temporary bonding adhesive may contain, along with the photo initiator, a sensitizer that is a component having the function of producing, or increasing, the reactivity of the photo initiator to a particular type or wavelength of light.

The aforementioned sensitizer is not particularly restricted, but examples such as anthracene, phenanthrene, chrysene, benzpyrene, fluoranthene, rubrene, pyrene, xanthone, indanthrene, thioxanthene-9-one, 2-isopropyl- 9H-thioxanthene- 9- one, 4-isopropyl- 9H-thioxanthene- 9-one, 1-chloro- 4-propoxy thioxanthone, and mixtures thereof can be given. The contained amount of such sensitizers, relative to 100 weight portions of the sensitizer mentioned above, is preferably 100 weight portions or less, and more preferably 20 weight portions or less.

Additionally the temporary bonding adhesive of the present invention may contain, in addition to the abovementioned components, for example, an acid scavenger. The aforementioned acid scavenger is a component that has the function of preventing acid that has been generated by the irradiation of light from dispersing to portions that have not been irradiated by light. That is, it is a component that has the function of preventing the unwanted curing of portions that have not been irradiated with light. By containing such an acid scavenger, the patterning precision can be made higher.

As the aforementioned acid scavenger, for example, amines (secondary amines, tertiary amines) such as tri (n-propy) amine, triethylamine, the compounds represented by the Formula (22) given below, and the compounds represented by the Formula (23) below or the like, and mixtures thereof, can be given.

[Formula 22]

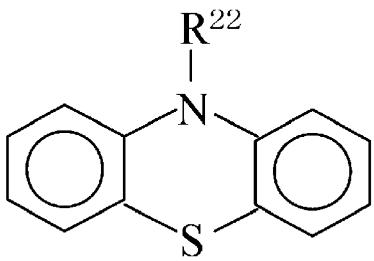

(22)

In the general Formula (22), $R^{22}$ is H or an alkyl group.

[Formula 23]

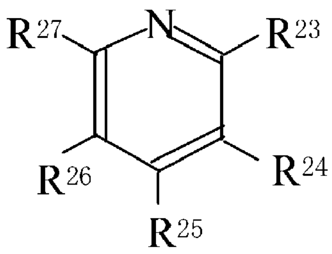

(2 3)

In the General Formula (23), $R^{23}$ through $R^{27}$ are H, or an arbitrary pair of them are methyl groups and the remainder are H.

Among these, it is preferable to use at least one type selected from the group comprising the compounds represented by the abovementioned General Formula (22) and the compounds represented by the abovementioned General Formula (23), and it is more preferable to use a compound represented by the abovementioned General Formula (22). Whereby the sensitivity of the resin composition to light can be made high, while the unwanted curing of portions that have not been irradiated with light can effectively be prevented.

The contained amount of the aforementioned acid scavenger, relative to 100 weight portions of the photo initiator mentioned above, is preferably 0.01 to 2 weight portions, and more preferably 0.02 to 1 weight portion. Whereby the unwanted curing of portions that have not been irradiated with light can be more effectively prevented.

Additionally the aforementioned temporary bonding adhesive may contain an antioxidant. The aforementioned antioxidant has the function of preventing the generation of undesirable acids, and the native oxidation of the resin composition.

The aforementioned antioxidant is not particularly restricted, but for example, Ciba IRGANOX (trademark) 1076, or Ciba IRGAFOS (trademark) 168, obtainable from Ciba Fine Chemicals Co. in Tarrytown, New York, can be used suitably.

Additionally other antioxidants such as Ciba Irganox (trademark) 129, Ciba Irganox 1330, Ciba Irganox 1010, Ciba Cyanox (trademark) 1790, Ciba Irganox 3114, and Ciba Irganox 3125, or the like, may be used.

The contained amount of the aforementioned antioxidant, relative to 100 weight portions of the aforementioned resin composition, is preferably 0.1 to 10 weight portions, and is more preferably 0.5 to 5 weight portions.

Additionally the aforementioned temporary bonding adhesive may contain, as needed, an additive agent such as an acryl based, silicone based, fluorine based, or vinyl based leveling agent, silane coupling agent, or diluent.

The aforementioned silane coupling agent is not particularly restricted, but it may for example, be 3-glycidoxy propyl trimethoxy silane, 3-glycidoxy propyl methyl diethoxy silane, 3-glycidoxy propyl triethoxy silane, p-styryl trimethoxy silane, 3-methacryloxy propyl methyl dimethoxy silane, 3-methacryloxy propyl methyl trimethoxy silane, 3-methacryloxy propyl methyl diethoxy silane, 3-methacryloxy propyl triethoxy silane, 3-acryloxy propyl trimethoxy silane, N-2- (amino ethyl)- 3-amino propyl methyl dimethoxy silane, N-2- (amino ethyl)- 3-amino propyl trimethoxy silane, N-2- (amino ethyl)-3-amino propyl triethoxy silane, 3-amino propyl trimethoxy silane, 3-amino propyl triethoxy silane, N-phenyl-3-amino propyl trimethoxy silane, 3-mercapto propyl methyl dimethoxy silane, 3-mercapto propyl trimethoxy silane, bis (triethoxy propyl) tetrasulfide, or 3-isocyanate pryopyl triethoxy silane, and these may be used alone, or by blending two or more types.

By having the aforementioned temporary bonding adhesive contain a silane coupling agent, it becomes possible to improve the adhesiveness to the semiconductor wafer or the supporting substrate.

The aforementioned diluent is not particularly restricted, but it may be, for example, a cycloether compound such as cyclohexane oxide or $\alpha$-pinene oxide; an aromatic cycloether such as [methylene bis (4,1- phenylene oxymethylene)] bis oxirane; or a cycloaliphatic vinyl ether compound such as 1,4-cyclohexane dimethanol divinyl ether.

By having the aforementioned temporary bonding adhesive contain a diluent, the fluidity of the temporary bonding adhesive can be improved, and it becomes possible to improve the wettability of the temporary bonding adhesive to a semiconductor wafer or a supporting substrate during the film forming step.

[Method for Manufacturing a Semiconductor Device]

Next, we shall explain one embodiment of the method for manufacturing a semiconductor device of the present invention.

The method for manufacturing a semiconductor device according to the present embodiment comprises a step wherein

a temporary bonding adhesive for a semiconductor wafer containing a resin composition wherefor the difference between the 95% weight loss temperature and the 5% weight loss temperature is

$$1 \text{ degree Celsius} \leq (95\% \text{ weight loss temperature}) - (5\% \text{ weight loss temperature}) \leq 300 \text{ degrees Celsius}$$

is provided in the form of a thin layer on top of a supporting substrate; a step wherein a semiconductor wafer is placed upon the surface of the aforementioned supporting substrate whereon the layer was provided; a step wherein said semiconductor wafer is stuck together with the aforementioned layer; a step wherein the aforementioned semiconductor wafer is processed; and a step wherein the aforementioned semiconductor wafer is detached from the aforementioned supporting substrate by heating the aforementioned layer.

In the manufacturing method for a semiconductor device comprising the abovementioned constitution, the difference between the 95% weight loss temperature and the 5% weight loss temperature is prescribed to be in the range 1 degree Celsius or greater, and 300 degrees Celsius or less, so the temperature range needed for thermal decomposition of the temporary bonding adhesive is narrow, and the time needed for thermal decomposition can be shortened, thereby suppressing damage to the semiconductor wafer.
Additionally it achieves the effects of it being difficult for the temporary bonding adhesive to remain on the semiconductor wafer, and the detachment of the semiconductor wafer after processing becomes easy.
Additionally since a wide range over which it is stably usable can be secured, it becomes possible to submit it to various processing steps while temporarily bonded to the supporting substrate.
Additionally since it can be formed as a layer on top of a supporting substrate having a smooth and sufficiently precise surface, it achieves the effect of having a high precision during processing such as grinding.

Additionally in the aforementioned manufacturing method for a semiconductor device, it is more preferable to contain a resin composition such that the difference between the 95% weight loss temperature and 5% weight loss temperature is

$$5 \text{ deg C} \leq (95\% \text{ weight loss temperature}) - (5\% \text{ weight loss temperature}) \leq 80 \text{ deg C.}$$

Whereby the time required for thermal decomposition can be shortened, and the effect of being able to secure a wide temperature range over which it is stably usable can be even more improved.

In the manufacturing method for a semiconductor device according to the present embodiment, as a temporary bonding adhesive for a semiconductor wafer, the abovementioned temporary bonding adhesive is utilized. That is, the temporary bonding adhesive used in the manufacturing method for a semiconductor device according to the present embodiment has the features of the abovementioned temporary bonding adhesive.
Herebelow, we shall explain each of the steps of the aforementioned manufacturing method for a semiconductor device.

(Thin layer Forming Step)

First, the step where a thin layer of a temporary bonding adhesive is provided on a supporting substrate or a semiconductor wafer, in order to fix a semiconductor wafer on a given supporting substrate, is carried out. The thin layer of a temporary bonding adhesive may be provided on either one of the supporting substrate or the semiconductor wafer. Regarding a method for providing the temporary bonding adhesive in the form of a thin layer, it can be carried out using a publicly known method such as the spin coat method, spray method, printing method, film transcription method, slit coat method, scan coating method, and the like, so there is the advantage that no new investments in facilities are needed. As a method for providing the temporary bonding adhesive in the form of a thin layer, the spin coat method is preferable, and it is preferable because it can form a uniform and flat thin layer.

(Bonding Step)

Next, the step in which the aforementioned supporting substrate or semiconductor wafer is placed upon the surface of the supporting substrate or the semiconductor wafer whereon a thin layer is provided, and the aforementioned supporting substrate or semiconductor wafer is stuck together with the aforementioned thin layer is carried out. For the bonding, a device such as a vacuum press or a wafer bonder or the like may be used.

(Processing Step)

Next, the step wherein the semiconductor wafer that has been bonded on top of the supporting substrate with the temporary bonding adhesive is processed is carried out.
The processing of the semiconductor wafer is grinding of the rear surface of the semiconductor wafer, etching for stress release, forming of Via holes, lithography coating, vapor deposition, and the like.
In the method for manufacturing a semiconductor device according to the present embodiment, since it can be formed as a thin layer on top of a supporting substrate having a smooth and sufficiently precise surface, so the effect of high precision in processing can be achieved.

(Heating Step)

Next, a step in which the temporary bonding adhesive in a form of a thin layer is heated and removed is carried out.
For the temporary bonding adhesive in the form of a thin layer, its thermal decomposition temperature is such that the difference between its 95% weight loss temperature and its 5% weight loss temperature is restricted to the range of 1 degree Celsius or greater, or 300 degrees Celsius or less, so that the temperature range required for thermal decomposition of the temporary bonding adhesive is narrow, and the time required for thermal decomposition can be shortened.
In this way heat damage to the semiconductor wafer can be suppressed.

(Detachment Step)

Next, the step of detaching the semiconductor wafer from the supporting substrate is carried out.
Here, "detachment" refers to the operation wherein the semiconductor wafer is peeled away from the supporting substrate. For example, this operation may be carried out by the method of detaching in the vertical direction relative to the surface of the supporting substrate, the method of detaching by sliding in the horizontal direction relative to the surface of the supporting substrate, or the method of detaching by tilting up the semiconductor wafer from one side of the semiconductor wafer. After the detaching step, residual temporary bonding adhesive that has remained on the semiconductor wafer or the supporting substrate may be removed. The removal method for the residual temporary bonding adhesive is not particularly restricted, but it may for example, be plasma treatment, chemical immersion treatment, grinding treatment, or heat treatment.
In the method of manufacturing a semiconductor device according to the present embodiment, since residual temporary bonding adhesive does not easily remain on the semiconductor wafer, detachment without stress is possible, and the effect of not sustaining damage and the like to the semiconductor wafer can be achieved.
Additionally since it evaporates during heating, and since residual temporary bonding adhesive does not easily remain on the semiconductor wafer, the following steps such as cleaning may be simplified, and there is the advantage that handling improves.
The use of a resin composition as a temporary bonding adhesive according to the present invention is a use of a resin composition as a temporary bonding adhesive for temporarily bonding a semiconductor wafer onto a supporting substrate in order to process a semiconductor wafer, and for detaching a semiconductor wafer from a supporting substrate by heating after processing, wherein the difference between the 95% weight loss temperature and the 5% weight loss temperature of said resin composition is

$$1 \text{ degree Celsius} \leq (95\% \text{ weight loss temperature}) - (5\% \text{ weight loss temperature}) \leq 300 \text{ degrees Celsius.}$$

The use of a resin composition as a temporary bonding adhesive according to the present invention is a use of a resin composition as a temporary bonding adhesive for temporarily bonding a semiconductor wafer onto a supporting substrate in order to process a semiconductor wafer, and for detaching a semiconductor wafer from a supporting substrate by heating after processing, wherein the difference between the 95% weight loss temperature and the 5% weight loss temperature of said resin composition is
5 degrees Celsius ≤ (95% weight loss temperature) - (5% weight loss temperature) ≤ 80 degrees Celsius.
Additionally said temporary bonding adhesive preferably contains a non-photosensitive polycarbonate based resin.
Additionally said temporary bonding adhesive preferably contains a non-photosensitive norbornene based resin.
A concrete example of a temporary bonding adhesive for a semiconductor wafer, a manufacturing method for a semiconductor device using it, and a use of a resin composition as a temporary bonding adhesive according to the

present invention, has now been explained, giving an embodiment, but the present invention is not restricted to this.

EXAMPLES

Herebelow, we shall explain, using embodiments, the detailed description of the temporary bonding adhesive for a semiconductor wafer and a method for manufacturing a semiconductor device according to the present invention, but the present invention is not restricted to the following embodiments.

(Embodiment 1)

In Embodiment 1, a temporary bonding adhesive was produced using the following compounds.

<Synthesis of 1,4-polybutyrane carbonate>

In a three neck flask provided with an agitator, a raw material loading opening, and a nitrogen gas introduction opening, 1,4-butanediol (168 g, 1.864 mol) and diethyl carbonate (264.2 g, 2.236 mol) were added, heated to 90 to 100 degrees Celsius under a nitrogen atmosphere, and the mixture was dissolved.
Next, after adding a 20% sodium ethoxide ethanol solution (80 ml, 0.186 mol), this was agitated for one hour at 90 to 100 degrees Celsius under a nitrogen atmosphere. After this, the interior of the reaction container was depressurized by around 30 kPa, and left at 90 to 100 degrees Celsius for 1 hour, and 120 degrees Celsius for 1 hour. After this, in a vacuum of 0.1 kPa, agitation was done for 1 hour at 150 degrees Celsius, and for 2 hours at 180 degrees Celsius.
The reactants obtained above were dissolved in tetrahydrofuran (2L), filtering was done, and the catalysis residue was removed. After this, this filtered liquid was put into a distilled water : methanol = 1 : 9 solution (20L), the precipitate was collected, and this was further washed sufficiently in a distilled water : methanol = 1 : 9 solution (10L), and 125 g of 1,4-polybutyrene carbonate (yield 48%) was obtained.
When the weight average molecular weight of the synthesized 1,4-polybutyrene carbonate was measured by GPC, it was found to be 35,000.

<Production of the temporary bonding adhesive >

100 g of the obtained 1,4-polybutyrene carbonate was dissolved in 900 g of anisole, producing a temporary bonding adhesive having a resin concentration of 10%.

(Embodiment 2)

<Synthesis of 5-decyl norbornene / 5-butyl norbornene / 5-phenetyl norbornene / 5-glycidyl oxymethyl norbornene = 20 mol% / 30 mol% / 20 mol% / 30 mol% copolymer>
In a sufficiently dried reaction container, ethyl acetate (600 g), cyclohexane (600 g), 5-decyl norbornene (75.74 g : 0.323 moles), 5-butyl norbornene (72.83 g : 0.485 moles), 5-phenetyl norbornene (64.07 g : 0.323 moles), and 5-glycidyl oxymethyl norbornene (87.36 g : 0.485 moles) was introduced. Dry nitrogen was blown through this system for 30 minutes at 40 degrees Celsius, and dissolved oxygen was removed. After this, a solution consisting of 6.58 g (0.0136 moles) of bis (toluene) bis (perfluorophenyl) nickel dissolved in 66.51 g of acetone was added to the reaction system.
The abovementioned system was raised from 40 degrees Celsius to 60 degrees Celsius over a period of 10 minutes, then the system was agitated for 3 hours while maintaining this temperature. To the obtained solution, a solution consisting of 245.0 g of glacial acetic acid and 462.0 g of 30% hydrogen peroxide solution added to approximately 705.0 g of pure water was added, and after agitating for 5 hours at 50 degrees Celsius, 150 g of isopropyl alcohol was added to the system. The agitation was stopped, and after the separated water layer was removed, the remaining organic layer was added to 450 g of pure water and 150 g of isopropyl alcohol in three batches, and washing was done by agitation and removal.
After washing, the organic layer was diluted with 400 ml of cyclohexane, and added to 6 times its amount of methanol (720 ml), and the precipitated polymer was recovered by filtering. After air drying the obtained solid matter for 18 hours, and drying for 24 hours under a reduced pressure of 1 mmHg, 284.7 g (yield 95.8%) of the target substance was obtained in the form of a solid resin.
When the weight average molecular weight of the synthesized 5-decyl norbornene / 5-butyl norbornene / 5-phenetyl norbornene / 5-glycidyl oxymethyl norbornene = 20 mol% / 30 mol% / 20 mol% / 30 mol% copolymer was measured by GPC, it was found to be 75,300.

<Production of the temporary bonding adhesive >

100 g of the obtained 5-decyl norbornene / 5-butyl norbornene / 5-phenetyl norbornene / 5-glycidyl oxymethyl norbornene = 20 mol% / 30 mol% / 20 mol% / 30 mol% copolymer was dissolved in 233.3 g of 2-heptanone, producing a temporary bonding adhesive with a 30% resin concentration.

The 5% weight loss temperature, the 50% weight loss temperature, and the 95% weight loss temperature of the 1,4-polybutylene carbonate and the 5-decyl norbornene / 5-butyl norbornene / 5-phenetyl norbornene / 5-glycidyl oxymethyl norbornene = 20 mol% / 30 mol% / 20 mol% / 30 mol% copolymer obtained in the abovementioned Embodiment 1 and 2 was measured (atmosphere : nitrogen, temperature rising rate : 5 degrees Celsius per minute) with a TG/DTA device (manufactured by Seiko Instruments). The results are shown in Table 1.

Additionally the decomposition time of the 1,4-polybutylene carbonate at its 5% weight loss temperature, and the decomposition time of the 5-decyl norbornene / 5-butyl norbornene / 5-phenetyl norbornene / 5-glycidyl oxymethyl norbornene = 20 mol% / 30 mol% / 20 mol% / 30 mol% copolymer at its 50% weight loss temperature was measured by a TG/DTA device (model number: 6200 Type, manufactured by Seiko Instruments) (atmosphere : nitrogen, temperature rising rate : rate at which the 5% weight loss temperature or the 50% weight loss temperature is reached in 30 minutes).
Based the obtained measured values, the point at which the 5% weight loss temperature was reached was taken to be the starting point (0 minutes), and the time at which the 95% weight loss temperature was reached was taken to be the aforementioned decomposition time. The results thereof are shown in Table 1.

[Table 1]

| | Emb.1 | Emb.2 |
|---|---|---|
| 1,4-polybutylene carbonate Mw: 35,000 | 100 g | |
| 5-decylnorbornene/5-butylnorbornene/5-phenetylnorbornene/ 5-glycidyloxymethylnorbornene (20 mol% / 30 mol% / 20 mol% / 30 mol%) | | 100 g |
| anisole | 900 g | |
| 2-heptanone | | 233.3 g |
| 5% weight loss temperature (deg C) | 277 | 274 |
| 50% weight loss temperature (deg C) | 311 | 418 |
| 95% weight loss temperature (deg C) | 330 | 533 |
| Decomposition Time at 5% weight loss temperature (min) | 10.0 | |
| Decomposition Time at 50% weight loss temperature (min) | | 105 |
| (95% weight loss temp.) - (5% weight loss temp.) (deg C) | 53 | 259 |

Next, using the temporary bonding adhesive according to the abovementioned Embodiments, the production of a semiconductor device was carried out.
First, using a spin coater, the temporary bonding adhesive obtained in the Embodiments was applied to an 8 inch transparent glass (rotation rate : 1,200 rpm, time : 30 seconds), and next, pre-baking was done on a hot plate at 120 degrees Celsius for 5 minutes, and a thin layer comprising the temporary bonding adhesive having a thickness of 5 μm was formed.
Next, a wafer bonder (Model Number SB-8e, manufactured by SUSS MicroTec) was used to temporarily fix an 8 inch silicon wafer (thickness 725 μm) to the 8 inch transparent glass through a thin layer comprising the temporary bonding adhesive (atmosphere : $10^{-2}$ mbar, temperature : 160 degrees Celsius, load : 10 kN, time : 1 minute).

Next, the sample wherein an 8 inch silicon wafer is temporarily bonded to an 8 inch transparent glass was put into an oven, a given temperature and time treatment was carried out, and the thermal decomposition of the temporary bonding adhesive was carried out.
The temporary bonding adhesive of Embodiment 1 was thermally decomposed at 320 degrees Celsius for 30 minutes. Additionally the temporary bonding adhesive of Embodiment 2 was thermally decomposed at 450 degrees Celsius for 120 minutes.

Finally the sample on which thermal decomposition was carried out was taken out of the oven, tweezers were placed in the space between the 8 inch transparent glass and the 8 inch silicon wafer, and the detachment of the 8 inch

silicon wafer was carried out. At this time, since the temporary bonding adhesive of both Embodiment 1 and Embodiment 2 were used, the detachment was done easily, without damaging the 8 inch silicon wafer.

In this way by using a temporary bonding adhesive according to the present invention, during the manufacturing method for a semiconductor device, detachment can be done easily and the time required for thermal decomposition can be shortened. Whereby, damage to the semiconductor wafer can be reduced.

## Claims

**1.** A temporary bonding adhesive for a semiconductor wafer, used for temporarily bonding a semiconductor wafer onto a supporting substrate in order to process a semiconductor wafer, and for detaching a semiconductor wafer from a supporting substrate by heating after processing, containing a resin composition such that the difference between the 95% weight loss temperature and the 5% weight loss temperature is

1 degree Celsius ≤ (95% weight loss temperature) – (5% weight loss temperature) ≤ 300 degrees Celsius.

**2.** A temporary bonding adhesive for a semiconductor wafer, used for temporarily bonding a semiconductor wafer onto a supporting substrate in order to process a semiconductor wafer, and for detaching a semiconductor wafer from a supporting substrate by heating after processing, containing a resin composition such that the difference between the 95% weight loss temperature and the 5% weight loss temperature is

5 degrees Celsius ≤ (95% weight loss temperature) – (5% weight loss temperature) ≤ 80 degrees Celsius.

**3.** A temporary bonding adhesive according to Claim 1 or 2, wherein said resin composition is such that the 5% weight loss temperature is 50 degrees Celsius or higher.

**4.** A temporary bonding adhesive for a semiconductor wafer according to any one of Claims 1 through 3, wherein said resin composition is such that the 50% weight loss temperature is 500 degrees Celsius or lower.

**5.** A temporary bonding adhesive for a semiconductor wafer according to any one of Claims 1 through 4, wherein said resin composition is such that the decomposition time at the 5% weight loss temperature is 1 minute or longer and 60 minutes or shorter.

**6.** A temporary bonding adhesive for a semiconductor wafer according to any one of Claims 1 through 4, wherein said resin composition is such that the decomposition time at the 50% weight loss temperature is 1 minute or longer and 120 minutes or shorter.

**7.** A temporary bonding adhesive for a semiconductor wafer according to Claim 5, wherein said temporary bonding adhesive for a semiconductor wafer contains a non-photosensitive polycarbonate based resin.

**8.** A temporary bonding adhesive for a semiconductor wafer according to Claim 6, wherein said temporary bonding adhesive for a semiconductor wafer contains a non-photosensitive norbornene based resin.

**9.** A method for manufacturing a semiconductor device, comprising
a step wherein, on a supporting substrate, a thin layer of a temporary bonding adhesive for a semiconductor wafer containing a resin composition such that the difference between the 95% weight loss temperature and the 5% weight loss temperature is

1 degree Celsius ≤ (95% weight loss temperature) – (5% weight loss temperature) ≤ 300 degrees Celsius

is provided on the supporting substrate or the semiconductor wafer;
a step wherein said supporting substrate or semiconductor wafer is placed upon the surface of said supporting substrate or semiconductor wafer whereon a thin layer is provided, and said supporting substrate or semiconductor wafer is stuck together with said thin layer;
and a step wherein said thin layer is heated and said semiconductor wafer is detached from said supporting substrate.

**10.** A method for manufacturing a semiconductor device, comprising
a step wherein, on a supporting substrate, a thin layer of a temporary bonding adhesive for a semiconductor wafer containing a resin composition such that the difference between the 95% weight loss temperature and the 5% weight loss temperature is

5 degrees Celsius ≤ (95% weight loss temperature) – (5% weight loss temperature) ≤ 80 degrees Celsius

is provided on the supporting substrate or the semiconductor wafer;
a step wherein said supporting substrate or semiconductor wafer is placed upon the surface of said supporting substrate or semiconductor wafer whereon a thin layer is provided, and said supporting substrate or semiconductor wafer is stuck together with said thin layer;
and a step wherein said thin layer is heated and said semiconductor wafer is detached from said supporting substrate.

**11.** A manufacturing method for a semiconductor device according to Claim 9 or 10, wherein said temporary bonding adhesive for a semiconductor wafer contains a non-photosensitive norbornene based resin.

**12.** A manufacturing method for a semiconductor device according to Claim 9 or 10, wherein said temporary bonding adhesive for a semiconductor wafer contains a non-photosensitive polycarbonate based resin.

**13.** A use of a resin composition as a temporary bonding adhesive for temporarily bonding a semiconductor wafer onto a supporting substrate in order to process a semiconductor wafer, and for detaching a semiconductor wafer from a supporting substrate by heating after processing, wherein the difference between the 95% weight loss temperature and the 5% weight loss temperature of said resin composition is

1 degree Celsius ≤ (95% weight loss temperature) – (5% weight loss temperature) ≤ 300 degrees Celsius.

**14.** A use of a resin composition as a temporary bonding adhesive for temporarily bonding a semiconductor wafer onto a supporting substrate in order to process a semiconductor wafer, and for detaching a semiconductor wafer from a supporting substrate by heating after processing, wherein the difference between the 95% weight loss temperature and the 5% weight loss temperature of said resin composition is

5 degrees Celsius ≤ (95% weight loss temperature) – (5% weight loss temperature) ≤ 80 degrees Celsius.

**15.** The use of a resin composition according to Claim 13 or 14, wherein said temporary bonding adhesive contains a non-photosensitive polycarbonate based resin.

**16.** The use of a resin composition according to Claim 13 or 14, wherein said temporary bonding adhesive contains a non-photosensitive norbornene based resin.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006504853 T
- JP 2006503335 T
- WO 1997033198 A
- WO 2000020472 A


### Non-patent literature cited in the description


- Encyclopedia of Polymer Science. John Wiley and Sons, 1988, 13708